# EUROPEAN PATENT APPLICATION

(11) **EP 4 761 193 A1**
(43) Date of publication of application: **17.06.2026**
(21) Application number: 24220279.4
(22) Date of filing: 16.12.2024
(51) Int. Cl.: H04L 25/03, H04L 25/06, H10D 30/00

(54) **INTRODUCING AN OFFSET IN A SLICER OF A DECISION-FEEDBACK EQUALIZER (DFE) CIRCUIT**

(71) Applicant: INOVA Semiconductors GmbH, 81379 München (DE)
(72) Inventor: Gönen, Burak, Toronto, M5C1C4 (CA)
(74) Representative: Reich, Jochen

(57) **Abstract**

The present invention provides an innovative method and apparatus for introducing a controlled offset in the slicer of a decision-feedback equalizer (DFE) circuit by utilizing the body effect of MOSFET transistors. Unlike prior art, which often relies on additional transistors, current sources, or complex configurations to achieve offset adjustments, this invention leverages the body terminal of MOSFET input transistors to adjust threshold voltages directly through a biasing control voltage. The control voltage is generated by a digital-to-analog converter (DAC), which independently biases the body terminals of the input transistors, allowing precise, dynamic, and energy-efficient offset adjustments.

## Description

The present invention provides an alternative method and apparatus for introducing a controlled offset in the slicer of a decision-feedback equalizer (DFE) circuit by utilizing the body effect of MOSFET transistors. Unlike prior art, which often relies on additional transistors, current sources, or complex configurations to achieve offset adjustments, this invention leverages the body terminal of MOSFET input transistors to adjust threshold voltages directly through a biasing control voltage. The control voltage is generated by a digital-to-analog converter (DAC), which independently biases the body terminals of the input transistors, allowing precise, dynamic, and energy-efficient offset adjustments.

This approach presents several key contributions over prior art. Traditional DFE circuits introduce offsets using additional components connected to the gate-source paths, which increases capacitive loading, thermal noise, and overall power consumption, thereby degrading the performance of the slicer. In contrast, by directly applying the offset through the MOSFET body terminals, this invention eliminates the need for extra transistors and current sources, preserving the slicer's speed, reducing power consumption, and improving circuit efficiency.

Moreover, the invention's configuration allows for fine-tuned, adaptive offset control that can respond to real-time signal conditions, making it suitable for both loop-unrolled and conventional DFE architectures. The DAC enables dynamic adjustments in response to environmental changes and varying signal characteristics, enhancing robustness and reliability. By using the body terminal bias for offset control, the invention offers a significant advancement over prior solutions, ensuring high-speed, high-accuracy signal processing while minimizing design complexity and power requirements, which are critical in modern communication systems.

In signal processing, a slicer is a device or circuit designed to convert analog input signals into digital output signals by "slicing" or thresholding the signal. Essentially, a slicer compares the incoming analog signal to a specified threshold to determine whether it should be interpreted as "high, 1" or "low, 0"

The process starts with the analog input signal, which often requires conditioning to prepare it for slicing. This conditioning might involve amplification, filtering, or impedance matching to ensure the signal is both strong and clean enough for accurate thresholding. Conditioning helps reduce any noise that could interfere with the slicer's performance.

At the core of the slicer is a comparator circuit, typically implemented using operational amplifiers or dedicated comparator ICs. The comparator receives the conditioned analog signal on one input and a predefined threshold level on the other. If the analog signal is above the threshold, the comparator outputs a high digital signal (representing logic "1"); if the signal is below the threshold, it outputs a low digital signal (logic "0").

In many slicer designs, the threshold is adjustable to adapt to changes in the input signal, either manually or automatically. Manual adjustments are typically made with a potentiometer, allowing the user to set the threshold as needed, while automatic adjustments are achieved through adaptive slicers. These adaptive designs adjust the threshold based on the average level or other statistical properties of the signal, enabling the slicer to handle varying signal conditions more effectively.

The output stage of the slicer is responsible for making the digital signal robust and compatible with downstream digital circuits. This stage often includes a digital output buffer or driver circuit, which strengthens the signal for further processing by devices such as microcontrollers, FPGAs, or digital signal processing (DSP) systems. In high-speed communication applications, the output may also be synchronized with a clock to create a stable digital data stream, ensuring reliable transmission of information.

Some slicer designs incorporate additional post-processing steps, such as edge-detection or pulse-shaping circuits, to further refine the signal's clarity and stability, especially in data communication applications. These post-processing steps can help ensure that the output signal remains accurate and clear, even at high speeds.

Slicers are fundamental in applications where analog signals need to be interpreted in binary form, making them essential for data communication, basic analog-to-digital conversion, and optical communication systems. In each case, the slicer effectively receives an analog signal, applies a threshold comparison, and outputs a clean digital signal, providing a crucial link in digital communication and processing systems.

In the state of the art, slicers present several limitations regarding construction, energy consumption, reliability, and speed. Traditional slicer circuits, particularly those using discrete components like operational amplifiers or dedicated comparators, can be relatively bulky and challenging to integrate into compact systems. This poses a limitation for applications requiring miniaturized devices, such as in the automotive industry, where space is at a premium, and integration density is critical. Reducing the component count and size often requires more complex integrated designs, which can drive up manufacturing costs.

Energy consumption is another concern especially in the field of e-mobility. Many conventional slicers are designed without a strong emphasis on energy efficiency, as they are typically used in stationary or low-mobility applications where power is readily available. However, in battery-powered or portable applications, the constant power draw of these circuits can be disadvantageous. Achieving high performance while minimizing power consumption usually requires specialized low-power design approaches, which can complicate the circuit design or reduce its performance.

Reliability and fault tolerance also present challenges. Although slicer circuits are relatively simple, they can be vulnerable to noise, input signal fluctuations, and threshold drifts over time. These issues can lead to signal misinterpretation, particularly in environments with significant electromagnetic interference. Furthermore, a failure in any critical component as required in the automotive industry, such as the comparator, may cause the slicer circuit to fail entirely, compromising the overall reliability of the system in which it is embedded.

Speed limitations are another drawback especially in real-time applications of a car. Although slicers can operate at reasonable speeds, their performance is often constrained by the switching speed of the comparators and other components involved. Traditional designs may have difficulty handling high-frequency signals, which is especially problematic in applications like optical or high-speed digital communications. Achieving very high-speed slicing generally requires advanced high-speed comparators and low-latency circuitry, which tend to increase both the cost and power consumption.

There is need in ongoing research and development to overcome these problems especially in the automotive industry, which seeks to improve circuit miniaturization, enhance power efficiency, strengthen fault tolerance, and boost operational speed to better meet the demands of modern, high-performance applications.

Accordingly, it is an object of the present invention to provide a method and apparatus for dynamically adjusting the threshold value in a receiver-side analog-to-digital converter, enhancing accuracy, adaptability, and processing speed in data signal conversion. The invention specifically aims to improve the precision of threshold adjustments by applying a controlled bias to the body terminal of MOSFET transistors, allowing fine modulation of the threshold voltage. This approach enhances the accuracy of data conversion without requiring additional components that could complicate the circuit or degrade performance. Another key objective is to increase signal processing speed. By enabling real-time, dynamic adjustments to the threshold value based on the characteristics of the incoming analog signal, the invention allows the converter to respond efficiently to high-speed data inputs and supports higher-frequency operation. Furthermore, the invention enhances adaptability and offset control by using digital-to-analog converters (DACs) to control the body bias. This enables adaptive offset adjustments that compensate for signal variations and correct offsets introduced by other circuit components, such as slicers, thereby improving overall signal integrity and reliability.

Additionally, the invention seeks to reduce power consumption and circuit complexity. By leveraging the existing body terminal instead of adding extra transistors or current sources, the invention maintains low energy requirements and a streamlined circuit design, making it compatible with both conventional and advanced decision-feedback equalizer (DFE) architectures. In summary, the object of the invention is to provide an efficient, flexible, and low-power solution for threshold control in analog-to-digital conversion, thereby enabling improved accuracy and performance in high-speed communication systems.

It is also an object of the present invention to provide a system arrangement being designed in accordance with the suggested method. Moreover, it is an object of the present invention to provide a respectively arranged computer program product and a computer-readable medium.

The object is solved by the subject-matter according to the independent claims. Further advantages are provided by the dependent claims.

Accordingly, a method for dynamically adjusting a threshold value for use in a receiver-side analog-to-digital converter is suggested, comprising: receiving a continuous analog data signal via a serial data line, whereby the analog data signal is evaluated at equidistant sampling points; evaluating the received analog data signal at a first predefined sampling point applying an initially defined threshold value as 0 or 1; consecutively evaluating the analog data signal at further consecutive sampling points following the first sampling point, whereby in each step of evaluating the previously used threshold value is adjusted in such a way that the threshold value is increased if the data signal immediately beforehand is evaluated as 1 and the threshold value is reduced if the data signal immediately beforehand is evaluated as 0, actively applying a controlled potential between a body and a source thereby altering an electric field within a conductive channel region and thereby modulating the converter's activation threshold value.

According to a further aspect of the present invention, applying a negative voltage to the body relative to the source in an NMOS transistor increases the threshold voltage of the receiver-side analog-to-digital converter. This provides the advantage that the threshold voltage can be raised in a controlled manner, improving the converter's selectivity and accuracy based on the nature of the incoming data signal.

According to a further aspect of the present invention, input transistors are configured with independent body terminal control, allowing the threshold values of specific transistors to be adjusted independently via digital-to-analog converters (DACs), thereby creating necessary offsets equivalent to those in conventional loop-unrolled decision-feedback equalizers

(DFEs). This provides the advantage that the threshold adjustment process becomes highly flexible, allowing each transistor to be finely tuned for optimal signal processing accuracy.

According to a further aspect of the present invention, the body terminal of the transistors is controlled via dedicated body contacts, which are configured with P-type material for NMOS transistors and N-type material for PMOS transistors to optimize threshold adjustment. This provides the advantage that the body effect can be precisely harnessed, enhancing the accuracy of threshold modulation and allowing for improved signal integrity in data reception.

According to a further aspect of the present invention, the body of an NMOS transistor is biased with a potential lower than 0V to increase the threshold voltage of the NMOS transistor, while the body of a PMOS transistor is biased with a potential higher than 0V to increase the threshold voltage of the PMOS transistor. This provides the advantage that threshold levels can be dynamically increased for both NMOS and PMOS transistors, enabling enhanced flexibility in setting thresholds across different operating conditions.

According to a further aspect of the present invention, the method is implemented in a silicon-on-insulator (SOI) process, allowing the option of forward biasing the body of the transistors, thereby providing flexible threshold modulation capabilities. This provides the advantage that the SOI structure enhances the linearity and effectiveness of threshold adjustments, enabling consistent performance in high-frequency applications.

According to a further aspect of the present invention, each PMOS transistor has a P-well and a deep N-well under its buried oxide layer, and each NMOS transistor has an N-well, allowing enhanced isolation and stability in the modulation of the activation threshold. This provides the advantage that the isolation between wells reduces interference and noise, contributing to a cleaner signal and more reliable threshold adjustment.

According to a further aspect of the present invention, the threshold voltage of the receiver-side analog-to-digital converter is selectively lowered by reducing the bias on the body terminal, thereby enhancing the converter's maximum operational frequency. This provides the advantage that lowering the threshold improves the speed of the converter, enabling higher-frequency operation suitable for fast data processing environments.

According to a further aspect of the present invention, the body biasing is adjusted to compensate for offsets introduced by slicers in the receiver, thereby improving the accuracy of data evaluation within the analog-to-digital conversion process. This provides the advantage that offset compensation corrects for potential slicer errors, enhancing the precision of the data evaluation process.

According to a further aspect of the present invention, the method is compatible with conventional decision-feedback equalizers (DFEs) without requiring loop-unrolling, providing a streamlined and effective offset control mechanism. This provides the advantage that the invention can be readily implemented in existing DFE architectures, enabling efficient offset control without extensive modifications to the circuit design.

According to a further aspect of the present invention, a DAC drives the body terminal of the input transistors in the slicer to adjust the threshold voltage precisely based on the received analog data signal and its recent evaluation history. This provides the advantage that the DAC-controlled bias allows for precise, adaptive threshold control in response to signal history, improving accuracy in real-time data processing.

According to a further aspect of the present invention, the DAC is configured to vary the control voltage applied to the body terminals, allowing real-time adaptation of the threshold based on the analog data signal characteristics, enhancing the dynamic response of the receiver-side analog-to-digital converter. This provides the advantage that real-time threshold adaptation makes the converter highly responsive to changing signal characteristics, resulting in better data integrity and faster response times.

According to an aspect of the present invention, a method for introducing an offset in a slicer of a decision-feedback equalizer (DFE) circuit comprises: providing a slicer that includes input transistors implemented as metal-oxide-semiconductor field-effect transistors (MOSFETs), each MOSFET having a gate terminal, a drain terminal, a source terminal, and a body terminal; applying a control voltage to the body terminals of the input transistors to adjust their threshold voltages through the body effect, thereby introducing a desired offset in the slicer without altering gate-source voltages; generating the control voltage using a digital-to-analog converter (DAC) to independently bias the body terminals of the input transistors; wherein the application of the control voltage to the body terminals introduces the offset without adding additional transistors or current sources, thereby avoiding degradation of the slicer's performance and preventing an increase in energy consumption. This provides the advantage that precise offset control is achieved without additional circuit complexity, maintaining the slicer's performance and energy efficiency.

According to an aspect of the present invention, each MOSFET body terminal is biased with an independently adjustable control voltage, allowing separate offset levels to be set for individual slicers within the DFE circuit. This provides the advantage that each slicer can be independently optimized, enhancing the overall adaptability and precision of the equalization process.

According to an aspect of the present invention, the control voltage applied to the body terminals is varied dynamically during operation to maintain optimal threshold voltage adjustments based on real-time signal conditions. This provides the advantage that the slicer can respond adaptively to changing signal conditions, improving the robustness and reliability of the DFE circuit.

According to an aspect of the present invention, the DAC used to generate the control voltage is calibrated at the initialization of the DFE circuit to ensure precise offset adjustments across all operating conditions. This provides the advantage that the offset is accurately set during initialization, promoting consistent and optimal performance over time.

According to an aspect of the present invention, the DAC is configured to generate a range of control voltages that enable both positive and negative threshold adjustments, allowing for flexible offset control based on the specific requirements of the receiver. This provides the advantage that the slicer can be finely tuned for various operating scenarios, enhancing its versatility and effectiveness in diverse applications.

According to an aspect of the present invention, the body terminals are biased to introduce opposing offsets across multiple slicers in a loop-unrolled DFE architecture, facilitating simultaneous threshold adjustments across all slicers. This provides the advantage that balanced offsets can be applied in parallel, increasing the speed and efficiency of the loop-unrolled DFE circuit.

According to an aspect of the present invention, the offset introduced by the body terminal biasing compensates for variations in the common-mode voltage of input signals to improve accuracy and signal integrity within the DFE circuit. This provides the advantage that the slicer's accuracy is enhanced, as it can better manage variations in common-mode voltage, improving the overall quality of the received signal.

According to an aspect of the present invention, the control voltage applied to the body terminals is configured to reduce capacitive loading on the slicer input transistors, thereby enhancing the speed and performance of the DFE circuit. This provides the advantage that capacitive loading is minimized, enabling higher operating speeds and increased performance in the slicer circuit.

According to an aspect of the present invention, the control voltage for body terminal biasing is adjusted periodically in response to environmental factors, such as temperature changes, to maintain consistent slicer performance. This provides the advantage that the slicer's performance remains stable over varying environmental conditions, contributing to long-term reliability.

According to an aspect of the present invention, the offset control provided through body terminal biasing is used in combination with additional filtering mechanisms in the DFE circuit to reduce noise and improve signal clarity. This provides the advantage that noise is reduced, enhancing the clarity and fidelity of the processed signals.

According to an aspect of the present invention, a feedback signal from the output of the slicer is generated to adjust the DAC settings, enabling adaptive offset correction based on previous decision outcomes in the DFE circuit. This provides the advantage that the offset can be adaptively corrected in response to slicer outputs, enabling improved accuracy and responsiveness in the DFE.

According to an aspect of the present invention, the slicer includes a differential amplifier configuration, and the control voltage applied to the body terminals is selected to balance the differential inputs, improving overall linearity of the slicer's output. This provides the advantage that linearity in the slicer output is improved, enhancing signal integrity and minimizing distortion in the equalization process.

According to an aspect of the present invention, an apparatus for introducing an offset in a slicer of a decision-feedback equalizer (DFE) circuit comprises: a slicer including input transistors each configured as a metal-oxide-semiconductor field-effect transistor (MOSFET), each MOSFET having a gate terminal, a drain terminal, a source terminal, and a body terminal; a digital-to-analog converter (DAC) configured to generate a control voltage and apply it to the body terminals of the input transistors to adjust their threshold voltages via the body effect, thereby introducing an offset in the slicer without modifying the gate-source voltages; wherein the control voltage applied to the body terminals introduces the offset without requiring additional transistors or current sources, thereby avoiding degradation of the slicer performance and preventing an increase in energy consumption. This provides the advantage that the apparatus achieves efficient offset control with reduced power consumption and without compromising the slicer's performance.

The suggested method is applicable to both loop-unrolled and conventional DFE architectures to enhance signal processing accuracy and efficiency. The feature "thereby avoiding degradation of the slicer's performance and preventing an increase in energy consumption" is optional as it defines a technical effect.

The invention can also be summarized as a method for compensating offset in a receiver circuit, the method comprising providing a decision-feedback equalizer (DFE) with a slicer circuit including an input transistor pair, the input transistor pair having a body terminal; generating an offset adjustment signal using a digital-to-analog converter (DAC); applying the offset adjustment signal to the body terminal of the input transistor pair to modulate a threshold level of the slicer circuit; and adjusting the offset of the slicer circuit by controlling the threshold level through the body terminal to reduce offset-induced error in signal processing, wherein the method enables offset compensation without altering the architecture of the decision-feedback equalizer, thereby improving signal accuracy and energy efficiency in the receiver circuit.

The invention described in Claim 1 provides a method to introduce a controlled offset in the slicer of a decision-feedback equalizer (DFE) circuit by applying a bias voltage to the body terminals of input transistors. This method utilizes the body effect to adjust the threshold voltage of these transistors, creating a desired offset without modifying the gate-source voltages or adding additional components, such as extra transistors or current sources, which would typically increase both the capacitive load and power consumption. This innovative approach is compatible with both loop-unrolled and conventional DFE architectures, enhancing the flexibility and performance of equalizer circuits in high-speed signal processing applications.

The slicer, used within the receiver section of the DFE circuit, includes input transistors configured as metal-oxide-semiconductor field-effect transistors (MOSFETs), each with gate, drain, source, and body terminals. Traditionally, offsets are introduced by manipulating the gate-source voltages or adding additional offset transistors, but this invention takes advantage of the body terminal, which influences the threshold voltage through the body effect. By applying a control voltage to the body terminals of the MOSFETs in the slicer's input stage, this method enables precise modification of the transistors' threshold voltages, thereby introducing a well-defined offset without altering the gate-source path. This offset adjustment is achieved through a digital-to-analog converter (DAC), which provides precise, adjustable control over the bias applied to the body terminals of the MOSFETs. This configuration allows for flexibility in setting different offset levels based on the requirements of the receiver circuit, which may vary depending on the application or signal conditions. The approach enables the slicer to adapt to different operating environments, making the design highly versatile and capable of compensating for various types of signal distortion or noise.

The method is compatible with different DFE architectures. In loop-unrolled DFEs, where multiple slicers may operate in parallel, the technique allows for uniform threshold adjustment across multiple slicers to ensure consistent offset control. In conventional DFE architectures with fewer components, the same method can be applied to achieve offset control without extensive modifications to the circuit. This universality provides a comprehensive solution for offset adjustment across a range of DFE designs.

This method provides several technical advantages. By using the existing body terminals of the MOSFETs, it eliminates the need for additional transistors or current sources, reducing component count and conserving space within the integrated circuit, which is advantageous for compact, high-density applications. It also minimizes energy consumption, as the offset is achieved by adjusting the body potential rather than adding active components or modifying the current path, enhancing the energy efficiency of the DFE circuit.

Traditional methods for introducing offset can degrade slicer performance by increasing capacitive load and thermal noise, but this approach maintains high slicer performance by avoiding added load on the gate-source path, which is critical for achieving high-speed operation and signal fidelity. As a result, the slicer exhibits improved accuracy and signal-to-noise ratio, essential for high-performance data communication systems. The use of a DAC to generate the body bias voltage enables precise, real-time control of the offset level, allowing the slicer to maintain optimal performance even as signal conditions fluctuate. This capability for dynamic control offers a high degree of fine-tuning, enhancing the robustness and adaptability of the circuit across a broad range of applications.

Furthermore, this method's compatibility with both loop-unrolled and conventional DFEs provides flexibility in application, allowing seamless integration across diverse DFE implementations without requiring significant modifications. This universal approach simplifies design processes, enabling rapid deployment across various signal processing applications. By ensuring precise control over the threshold voltage and therefore the slicer's offset, the method contributes to more accurate decision-making within the DFE, leading to reduced error rates and improved signal clarity. In high-speed data communication systems, this accuracy enhancement supports reliable data interpretation, resulting in robust and efficient communication performance.

In summary, this invention offers a highly efficient, adaptable method for offset control in DFEs by leveraging the body effect to adjust threshold voltages and introduce precise offsets. The method's technical advantages-such as reduced component count, lower power consumption, high slicer performance, enhanced signal fidelity, and applicability across DFE architectures-enhance accuracy, efficiency, and versatility in high-speed signal processing systems.

According to an aspect of the present invention, a semiconductor device incorporates multiple conductive terminals, including a control terminal, output terminal, input terminal, and substrate terminal, where the substrate terminal influences the activation level of the device. By applying a controlled potential between the substrate terminal and the input terminal, the electric field within the conductive channel region is altered, allowing modulation of the device's activation threshold. For specific configurations, a relative difference in potential applied between the substrate and input terminals enables an increase in the activation threshold.

This capability is employed to introduce an offset between signal processing components. In this embodiment, input transistors possess independently controllable substrate terminals, which are adjustable via digital-to-analog converters (DACs). These DAC-driven substrate controls facilitate precise offset creation, effectively replicating the functionality of conventional processing architectures without compromising signal processing accuracy or increasing energy consumption. This is achieved by utilizing the existing substrate terminal for fine-tuned threshold adjustments, offering significant technical effects in terms of improved device flexibility, reduced energy demand, and enhanced stability in signal processing applications.

According to an aspect of the present invention, a technique is employed to enhance the speed of a decision-feedback equalizer (DFE) by precomputing possible signal adjustment values before final decisions are made within processing units. This approach involves calculating all potential adjustment values corresponding to each possible configuration of input symbols, prior to the decision-making step. The calculated values are then applied as offsets across multiple processing units, where each unit corresponds to a unique combination of adjustment values.

To execute this method, each processing unit is activated by a timing signal, enabling it to generate all possible output decisions simultaneously. A selection component then dynamically chooses the correct decision based on previously made decisions, allowing for rapid response times. This technique significantly accelerates the DFE's operation by reducing the time needed for real-time decision processing.

The technical effects of this embodiment include substantial improvements in DFE processing speed, facilitating faster data communication rates and enhancing signal integrity. The offset values can be initialized during the start-up phase of the communication link or recalculated in the background during operation to maintain optimal signal quality. This adaptability further improves link robustness and performance across varying signal conditions.

According to an aspect of the present invention, an offset in an unrolled decision-feedback equalizer (DFE) is introduced through the differential input terminals of a signal processing component. In typical receiver designs, this processing component is implemented as a fully-differential circuit with an amplification stage. The differential inputs are connected to input transistors, which may be configured using either n-type or p-type transistors, depending on design requirements. This differential amplifier stage provides initial gain and then drives a latching mechanism.

The latch employs positive feedback to achieve rapid, high-gain amplification, resulting in a quick transition from analog input signals to a stable digital output. This configuration allows for precise offset control within the unrolled DFE architecture.

The technical effects of this approach include enhanced speed and sensitivity of the signal processing component, contributing to faster and more accurate data conversion. By enabling differential offset introduction, the embodiment also improves noise rejection and signal clarity, leading to a more robust performance in high-speed communication systems.

According to an aspect of the present invention, an additional transistor pair is incorporated into the signal processing circuit to introduce an adjustable offset voltage to a pre-amplifier stage. This offset is generated by differential voltage inputs provided through a digital-to-analog converter (DAC), which receives a control signal from a digital source. The resulting offset is introduced to the processing unit in a differential manner, with one polarity applied to a first set of inputs and the opposite polarity applied to a second set.

In this embodiment, the processing unit is part of an unrolled decision-feedback equalizer (DFE) configuration, in which input terminals are connected to alternating positive and negative differential inputs. Control signals adjust the DAC to provide positive and negative offset voltages, applied to designated transistors within each signal processing unit, creating a differential offset with opposing polarities across two separate units. The outputs of these units are then directed to a selection component, which dynamically chooses the appropriate signal path based on prior outputs.

The technical effects of this configuration include enhanced flexibility in adjusting offset voltages to optimize the signal processing performance. By enabling precise control over the differential offset with opposing polarities, this approach improves the accuracy and robustness of signal decisions within high-speed equalization circuits. Additionally, it reduces potential latency by allowing simultaneous signal path comparisons, resulting in faster and more reliable data processing within the communication link.

According to an aspect of the present invention, a solution is provided to address challenges associated with increased capacitive load, thermal noise, and power consumption in offset adjustment circuits within signal processing components. Traditional designs that incorporate additional transistors to introduce offset voltages often experience reduced signal processing efficiency due to a rise in capacitive load and amplified thermal noise at the output stage. These issues result from the increased transistor count required to implement the offset, which can negatively impact the speed and accuracy of the signal processing element.

Moreover, in designs where offset voltages are generated through digital-to-analog converters (DACs), there is a requirement for precise alignment between the DAC's output common-mode level and the input common-mode level of the signal processing component. This alignment is challenging to achieve accurately, and even minor discrepancies in common-mode voltage can cause operational instability or render the component inoperable.

In addition to these performance impacts, the inclusion of extra current sources to support additional transistors for offset generation also increases the overall energy consumption of the circuit.

The technical effects of this improved embodiment include enhanced slicer performance due to a reduction in both capacitive loading and thermal noise, resulting in a faster and more accurate signal processing response. By addressing the common-mode matching requirement, the embodiment ensures stable and reliable operation of the signal processing component. The reduction in energy demand due to fewer required current sources further improves the circuit's efficiency, making it more suitable for high-speed, low-power applications.

According to an aspect of the present invention, a semiconductor device is configured with four terminals, where an additional control function is provided through the terminal connected to the device substrate. This configuration allows the substrate terminal to impact the activation level of the device by adjusting the potential difference between the substrate and the input region. By modulating this potential difference, the electric field within the conductive path is altered, leading to a change in the device's activation threshold.

In particular, adjusting the substrate potential relative to the input enables the introduction of a controlled offset that can be applied across signal processing units within the device. Through independently adjustable substrate control for specific transistors, the embodiment utilizes digital-to-analog converters to create precise offsets equivalent to those used in conventional configurations without additional circuitry.

The technical effects of this approach include enhanced control over threshold voltage adjustments without adding components that could impact performance or power efficiency. By leveraging the existing substrate terminal, this design avoids additional capacitive loading and power consumption, thereby maintaining high processing performance and ensuring low energy use within the signal processing unit. This configuration is especially beneficial in applications where precise offset control is essential for robust signal interpretation without compromising processing speed or efficiency.

According to an aspect of the present invention, a semiconductor device utilizes a specialized process technology to independently control the body bias of MOS transistors, enhancing threshold voltage modulation and device performance. In a conventional bulk CMOS process, the body of an n-type transistor is typically connected to the substrate, which is positively doped and grounded. However, certain advanced process technologies enable independent body biasing. In technologies with a deep-well structure, it is feasible to control the body potential of n-type transistors independently, while body biasing for p-type transistors remains universally achievable.

The effect of body bias control on threshold voltage adjustment is particularly pronounced and linear in silicon-on-insulator (SOI) processes. In an SOI structure, a buried oxide layer beneath the channel region acts as an insulator, separating the transistor channel from the substrate, which allows precise control over the body potential through dedicated contacts. For n-type transistors, applying a lower-than-ground potential to the body raises the threshold voltage, whereas for p-type transistors, applying a higher-than-ground potential similarly raises their threshold. This method of threshold control in SOI processes is notably more linear and effective compared to conventional bulk CMOS.

Furthermore, some SOI processes support forward body biasing, allowing for threshold voltage reduction by applying a higher potential to the n-type transistor body and a lower potential to the p-type transistor body. This reduction in threshold voltage directly enhances the device's maximum operational frequency, thereby supporting higher-speed applications.

The technical effects of this embodiment include improved control over threshold voltages with enhanced linearity, allowing for precise tuning of transistor behavior across a range of operating conditions. Additionally, by enabling both increases and decreases in threshold voltage, this approach offers greater flexibility in power-performance optimization, supports higher operational frequencies, and enables more efficient high-speed circuit designs.

According to an aspect of the present invention, a method is provided to adjust the operational characteristics of signal processing components to compensate for inherent offsets, enhancing performance in receiver circuits. This approach is compatible with conventional decision-feedback equalizers (DFEs) that do not employ unrolled architectures. Here, an adjustment component, such as a digital-to-analog converter (DAC), is utilized to control the substrate terminal of the input transistors within the processing unit, thereby fine-tuning the threshold levels.

The technical effects of this embodiment include improved accuracy and reliability of the signal processing components by minimizing offset errors, leading to enhanced signal clarity and reduced error rates in receiver applications. This approach enables effective offset compensation without the need for architectural changes, allowing for streamlined integration into existing receiver designs. Additionally, by leveraging substrate bias control, this method maintains energy efficiency while providing flexible offset adjustments, making it advantageous for high-performance and low-power applications.

The suggested method according to an aspect of the present invention begins with receiving an analog data signal over a serial data line. This analog signal is then evaluated at equidistant sampling points, meaning the signal is periodically sampled at uniform intervals. By consistently sampling at these regular points, the continuous analog signal can be systematically analyzed and prepared for digitalization, allowing each sampled value to represent the signal's state at that precise moment in time. This structured approach facilitates an accurate and consistent digital representation of the original analog data.

The suggested method involves evaluating the received analog data signal at a predefined sampling point to initiate digitalization. At this specific sampling moment, the analog signal's value is compared against an initially defined threshold. If the analog signal exceeds this threshold, it is assigned a digital value of 1; if it is below the threshold, it is assigned a digital value of 0. This binary assessment forms the basis of converting the continuous analog signal into a discrete digital form by determining each sampled point as either a high or low state based on the initial threshold.

The "body effect" or "back-gate effect" in a MOSFET according to an aspect of the present invention describes how the voltage difference between the body (substrate) and the source influences the MOSFET's threshold voltage, or the point at which it begins to conduct. According to an aspect of the present invention this effect is particularly relevant in digital-to-analog converters (DACs), where precise control over the MOSFET characteristics is essential to achieve accurate analog signal output.

Typically, the threshold voltage of a MOSFET, or the gate-source voltage needed to allow current flow, is determined by the device's physical design. However, the body effect introduces an additional dependency: as the voltage difference between the body and source increases, the threshold voltage rises. This happens because the electric fields in the substrate change, modifying the conditions needed for the channel to conduct.

In DACs, this effect poses several challenges because the accuracy and stability of MOSFETs are critical. A variable threshold voltage due to the body effect can lead to nonlinear conversion. This means that the DAC's analog output may not precisely follow the expected values, as the MOSFETs might turn on at different voltages than originally intended. This is especially problematic in current-source-based DACs, where MOSFETs often function as matched current sources. When the threshold voltage varies, the resulting current levels can fluctuate, leading to inaccuracies in the analog output. This issue is overcome by the present invention and hence the suggested feature combination, wherein the underlying problem is also addressed in the art suggesting different technical teachings.

Furthermore, the body effect is also temperature-dependent. Since the effect is based on the physical properties of the MOSFET substrate, temperature changes can amplify or reduce it, further impacting the DAC's stability.

The object is also solved by a system arrangement for dynamically adjusting a threshold value for use in a receiver-side analog-to-digital converter, comprising: a receiving unit arranged to receive a continuous analog data signal via a serial data line, whereby the analog data signal is evaluated at equidistant sampling points; an evaluation unit arranged to evaluate the received analog data signal at a first predefined sampling point applying an initially defined threshold value as 0 or 1; a further evaluation unit arranged to consecutively evaluate the analog data signal at further consecutive sampling points following the first sampling point, whereby in each step of evaluating the previously used threshold value is adjusted in such a way that the threshold value is increased if the data signal immediately beforehand is evaluated as 1 and the threshold value is reduced if the data signal immediately beforehand is evaluated as 0, a controller unit arranged to actively apply a controlled potential between a body and a source thereby altering an electric field within a conductive channel region and thereby modulating the converter's activation threshold value.

The object is also solved by a system arrangement for introducing an offset in a slicer of a decision-feedback equalizer (DFE) circuit, comprising: a slicer that includes input transistors implemented as metal-oxide-semiconductor field-effect transistors (MOSFETs), each MOSFET having a gate terminal, a drain terminal, a source terminal, and a body terminal; a control unit for applying a control voltage to the body terminals of the input transistors to adjust their threshold voltages through the body effect, thereby introducing a desired offset in the slicer without altering gate-source voltages; a control unit arranged to generate the control voltage using a digital-to-analog converter (DAC) to independently bias the body terminals of the input transistors; wherein the application of the control voltage to the body terminals introduces the offset without adding additional transistors or current sources, thereby avoiding degradation of the slicer's performance and preventing an increase in energy consumption.

The object is also solved by a computer program product comprising instructions to cause the arrangement to execute the steps of the method as well by a computer-readable medium having stored thereon the computer program.

It is of special advantage that the method as suggested above can be executed using structural features of the suggested device and control unit. Accordingly, the method teaches steps which are arranged to operate the suggested device. Furthermore, the device comprises structural features allowing the accomplishment of the suggested method. In addition, a computer program and a computer program product respectively is suggested comprising instruction which perform the suggested method when executed on a computer or the device according to the present invention. Furthermore, the instructions provide means for implementing the structural features of the claimed device. Accordingly, an operable image of the structural features of the device can be created. Likewise, an arrangement comprising the structural device features is provided.

Wherever, structural features are provided they can likewise be established virtually thereby creating a virtual instance of physical structures. For instance a device can likewise be emulated. It may be the case that single sub steps are known in the art but the overall procedure still delivers a contribution in its entireness. Where technical effects are provided in the claims these are for clarification only and can be omitted.

Further advantages, features and details of the invention emerge from the following description, in which aspects of the invention are described in detail with reference to the drawings. The features mentioned in the claims and in the description can each be essential to the invention individually or in any combination. The features mentioned above and those detailed here can also be used individually or collectively in any combination. Functionally similar or identical parts or components are in some cases provided with the same reference symbols. The terms "left", "right", "top" and "bottom" used in the description of the exemplary aspects relate to the drawings in an orientation with normally legible figure designation or normally legible reference symbols. The aspects shown and described are not to be understood as conclusive, but are exemplary for explaining the invention. The detailed description is provided for the information of the person skilled in the art; therefore, in the description, known circuits, structures and methods are not shown or explained in detail in order not to complicate the understanding of the present description. The invention will now be described merely by way of illustration with reference to the accompanying figures, which show:
- Figure 1:: a flow chart of a method for dynamically adjusting a threshold value for use in a receiver-side analog-to-digital converter according to an aspect of the present invention;
- Figure 2:: a diagram illustrating the underlying problem and the implications for a method for dynamically adjusting a threshold value for use in a receiver-side analog-to-digital converter;
- Figure 3:: a schematic illustration of a decision-feedback equalizer (DFE) slicer circuit that applies an offset based on previous decision values, according to an aspect of the present invention;
- Figure 4:: a diagram demonstrating the loop-unrolling technique for DFEs, where all potential equalization values are precomputed and introduced as offsets in the slicers, enhancing processing speed as proposed in the invention;
- Figure 5:: a circuit diagram showing the implementation of offset in a slicer via differential inputs in a fully differential preamplifier, which subsequently drives a latch for high-gain digital output conversion;
- Figure 6:: a configuration highlighting a previous method of adding offset to the slicer preamplifier by employing a secondary pair of transistors, as discussed in the context of the invention;
- Figure 7:: an illustration of a slicer setup with increased capacitive load and thermal noise due to added transistors, demonstrating performance issues that the invention aims to overcome;
- Figure 8:: a schematic detailing the use of independent body terminal control in input transistors for offset creation, utilizing the body effect to maintain slicer performance without additional power consumption, as implemented in the invention;
- Figure 9:: a cross-sectional view of a silicon-on-insulator (SOI) process showing the isolated control of body potentials in NMOS and PMOS transistors, providing linear threshold voltage modulation as utilized in the invention; and
- Figure 10:: a cross-section illustrating an SOI process configuration that enables forward body biasing, allowing threshold voltage reduction to increase maximum operational frequency, as supported by the invention's approach.

The figures contain abbreviations and technical terms which are understood by the person skilled in the art and are common in the business and are therefore not translated.

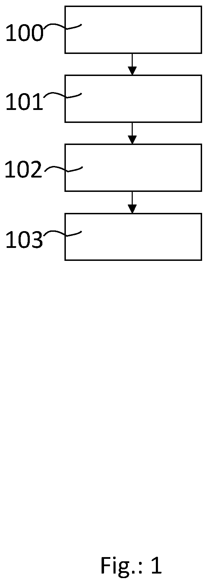

Figure 1 shows in a schematic flow chart a method for dynamically adjusting a threshold value for use in a receiver-side analog-to-digital converter, comprising: receiving 100 a continuous analog data signal via a serial data line, whereby the analog data signal is evaluated at equidistant sampling points; evaluating 101 the received 100 analog data signal at a first predefined sampling point applying an initially defined threshold value as 0 or 1; consecutively evaluating 102 the analog data signal at further consecutive sampling points following the first sampling point, whereby in each step of evaluating 102 the previously used threshold value is adjusted 103 in such a way that the threshold value is increased if the data signal immediately beforehand is evaluated as 1 and the threshold value is reduced if the data signal immediately beforehand is evaluated as 0, actively applying 103 a controlled potential between a body and a source thereby altering an electric field within a conductive channel region and thereby modulating the converter's activation threshold value.

Figure1 can likewise be interpreted as showing a method for introducing an offset in a slicer of a decision-feedback equalizer DFE circuit, the method comprising: providing 100 a slicer that includes input transistors implemented as metal-oxide-semiconductor field-effect transistors MOSFETs, each MOSFET having a gate terminal, a drain terminal, a source terminal, and a body terminal; applying 101 a control voltage to the body terminals of the input transistors to adjust their threshold voltages through the body effect, thereby introducing a desired offset in the slicer without altering gate-source voltages; generating 102 the control voltage using a digital-to-analog converter DAC to independently bias the body terminals of the input transistors; wherein the application of the control voltage to the body terminals introduces 103 the offset without adding additional transistors or current sources, thereby avoiding degradation of the slicer's performance and preventing an increase in energy consumption.

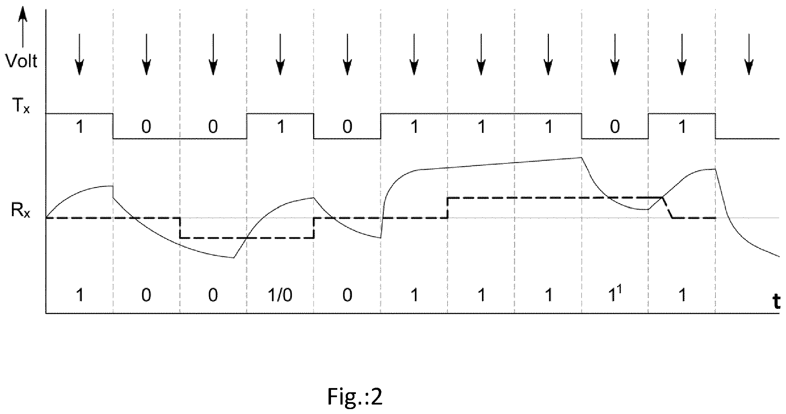

Figure 2 illustrates the operation of a receiver-side analog-to-digital converter (ADC) as it dynamically adjusts the threshold value in response to an incoming data signal. The top part of the figure, labeled T_x, represents the transmitted (input) signal with binary states "1" and "0" over time. The bottom part, labeled R_x, represents the received signal waveform at the receiver after undergoing possible signal degradation or noise. "t" on the right side indicates the ongoing time dimension.

In this context, the invention applies a dynamically adjustable threshold to evaluate the received analog signal accurately. The received signal R_x shows a fluctuating waveform that crosses above and below a dynamically adjusted threshold (indicated by a dashed line). According to the invention, this threshold is adjusted depending on the previously evaluated bit. If the last bit was a "1," the threshold increases slightly; if the last bit was a "0," the threshold decreases slightly. This approach compensates for inter-symbol interference (ISI) and mitigates noise, enabling more accurate binary decisions in fluctuating signal conditions.

The figure also illustrates how the invention applies a controlled potential between the body and source of the MOSFET input transistors within the ADC, adjusting the effective threshold dynamically. For example, when the threshold voltage needs to be increased (as shown after a "1" is detected), the body effect is utilized to increase the threshold via a negative body-source potential. Similarly, the threshold voltage can be decreased after a "0" is detected. This adaptation reduces errors due to signal distortion and enhances the reliability of the ADC in high-speed digital communication systems.

Figure 2 shows the adaptive decision thresholds of a Decision-Feedback Equalizer DFE according to an aspect of the present invention. However, there are three decision thresholds shown (low, mid, and high levels). In general, the present invention is also directed towards a 2-level DFE (high and low). Figure 2 provides a valid DFE implementation but the present invention is by no means restricted towards such an implementation. The aspects of both a 2-level and a 3-level Decision-Feedback Equalizer (DFE) in the present invention provide significant technical advantages by ensuring greater flexibility and adaptability to a wide range of signal conditions and application requirements. The 3-level DFE, with its low, mid, and high decision thresholds, offers enhanced accuracy in environments with higher noise levels or more complex signal characteristics. The additional mid-level threshold allows for finer granularity in decision-making, effectively reducing the likelihood of errors and improving overall signal quality. On the other hand, the 2-level DFE, which operates using only high and low thresholds, is simpler in design and requires fewer computational resources. This makes it particularly well-suited for applications where efficiency and low power consumption are critical, while still delivering reliable performance under standard signal conditions. By supporting both approaches, the invention combines the strengths of enhanced accuracy and computational efficiency, making it adaptable to diverse technological needs and therefore contributes over the art.

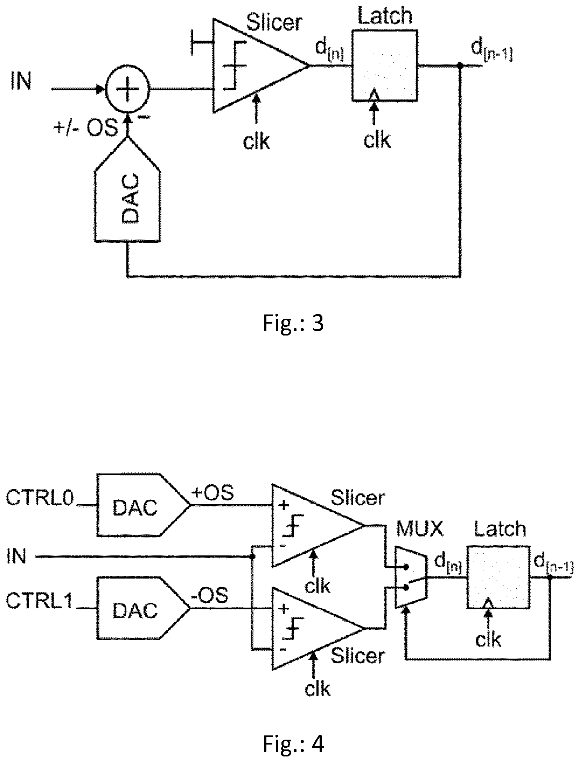

This present invention is about an efficient method of loop-unrolled decision feedback equalization (DFE) using the back-gate of MOSFETs. Channel loss-induced symbol interference (ISI) is overcome by DFEs in conventional receivers by changing the sampling threshold to increase the signal to noise ratio (SNR). For example, as shown in Figure 3, a DFE slicer can sample the input with an offset of +OS or - OS depending on the previous decision value d[n-1] (+OS if d[n-1] is 0, or - OS if d[n-1] is 1). This is achieved by using a digital to analog converter (DAC) creating offset values dynamically and subtracting from the input signal in current, voltage, or charge domain. Feeding back of the previous decision d[n-1] requires a high speed feed-back loop, which limits the achievable decision speed of a DFE.

Loop-unrolling is a technique used to enhance the speed of a DFE by precomputing all possible equalization values before a decision is taken at the slicer. First, all potential equalization values are precomputed for each possible combination of the input symbols before the actual decision is made. These equalization values are introduced as an offset at the slicers, which are now numbered as many as the possible combinations of the equalization values as shown in Figure 4. These precomputed values are then sliced, by triggering each of these slicers with a clock edge, to obtain all possible decisions. A multiplexer (MUX) then selects the correct decision based on past decisions. This improves the speed of the DFE considerably. The voltage or current offset values can be computed at the start-up of the communication link or during the link operation in the background to optimize the quality of the received signal.

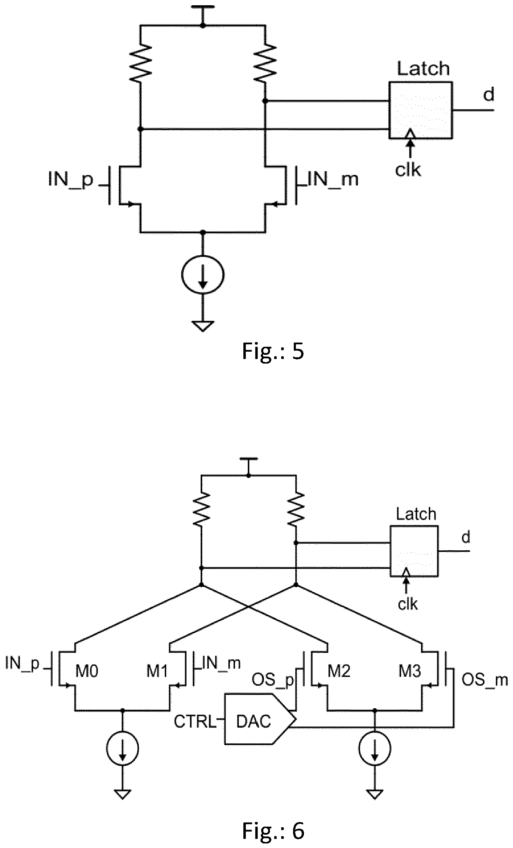

The offset in a loop-unrolled DFE is often introduced by using the differential inputs of a slicer. In most receiver implementations a slicer is a fully-differential circuit implemented with differential pair preamplifier similar to shown in Figure 5 where the differential input signals IN_p and IN_m are applied to input transistors (here drawn as NMOS but can be PMOS). The differential amplifier makes gain which drives a latch. The latch uses positive feedback to create a large gain in a short amount of time and creates digital output d.

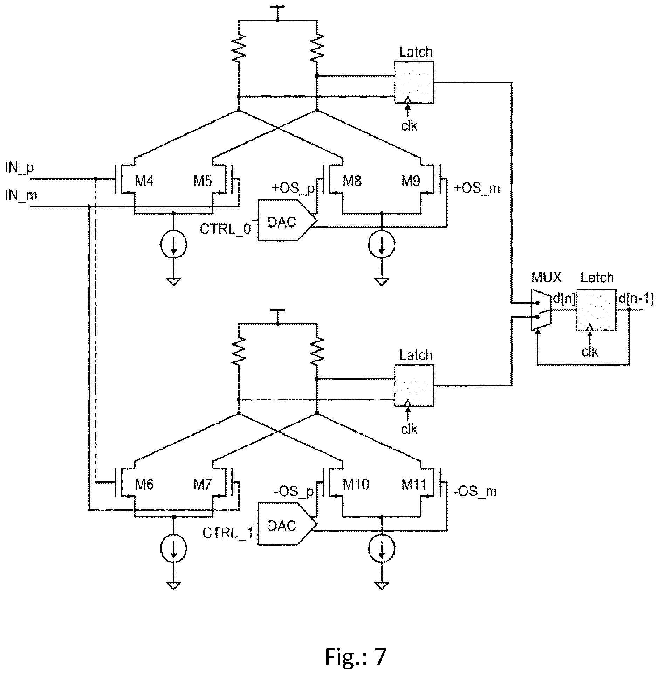

As shown in Figure 6 in the previous art a second pair of transistors (M2 and M3 in Figure 6) is used to add the necessary offset to the slicer preamplifier. The inputs of M2 and M3 are OS_p and OS_m, which are differential offset voltages created by a DAC from a digital control signal CTRL. This slicer with extra input pair is then used in a loop-unrolled DFE as shown in Figure 7. The transistors M4, M6 are connected to positive input IN_p and M5, M7 are connected to the negative input IN_m. The control signals CTRL_0 and CTRL_1 are connected to the DACs to create +OS_p, +OS_m, -OS_p, and -OS_m which are connected to the gates of the transistors M8, M9, M10, and M11 respectively. In this way the two slicers have the same differential offset voltage amplitude but the opposite polarity. The outputs of the slicers are then connected to a multiplexer (MUX) which then selects the correct decision depending on the previous decision.

The implementation in Figure 7 degrades the slicer performance due to doubling of the capacitive load and the total thermal noise at the output of the preamplifiers due to doubling of the number of transistors. Furthermore, the DACs used to create offset voltages should match the same input common-mode level as the slicer inputs, which is hard to achieve accurately. If the inaccuracy in the common mode voltage difference is large the slicer might be inoperable. The total energy consumption is also increased due to the extra current sources shown in Figure 7 connected to M8, M9, M10, and M11.

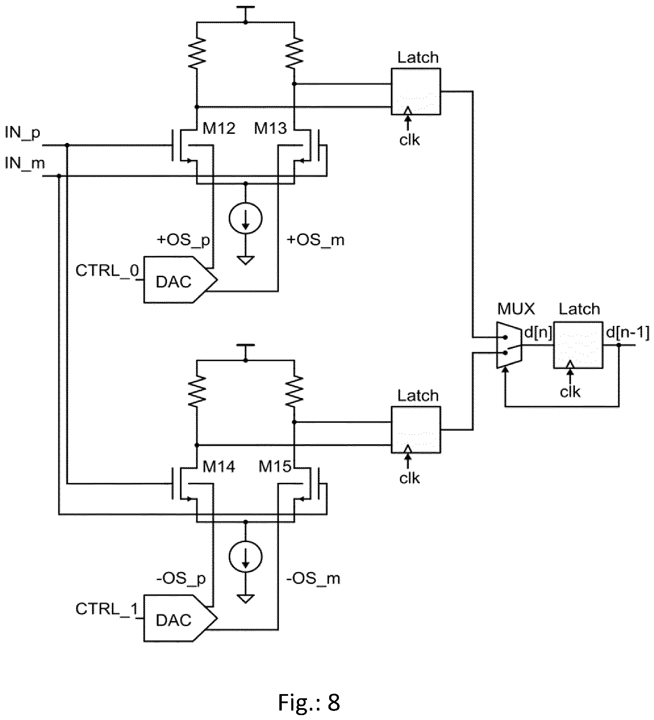

A MOSFET has four terminals: the gate, drain, source, and body (or backgate). The body can influence the threshold voltage V_{T} of the MOSFET. This is known as the body effect. When a voltage is applied between the body and the source, it affects the electric field in the channel region. Applying a negative voltage to the body relative to the source (for an NMOS) increases the threshold voltage. This effect can be used to create an offset introduced between the slicers, as shown in Figure 8. The input transistors M12, M13, M14, and M15 have independent body terminal control that can be driven by DACs to create the necessary offsets equivalent to the operation of the conventional loop-unrolled DFE. This approach does not degrade the performance of the slicer and does not increase its energy consumption due to the usage of the readily available body terminal.

The "drain" is a terminal specific to field-effect transistors (FETs), particularly in MOSFETs, which are a common type of FET. In a MOSFET, there are three primary terminals: the source, gate, and drain. The drain is where the current exits the FET after flowing through the channel that forms between the source and the drain, depending on the voltage applied to the gate. In contrast, "ground" refers to the reference point in an electrical circuit, usually considered to be at zero volts, against which other voltages in the circuit are measured. Ground acts as a common return path for electric current and provides a stable reference level for the entire circuit. In certain circuit designs, especially those involving N-channel MOSFETs, the drain may indeed be connected to ground. This is typically a design choice that depends on the circuit configuration rather than a standard rule. For instance, in some cases, an N-channel MOSFET might have its source connected to a lower voltage or a negative potential while the drain is at ground. However, even in such cases, "drain" and "ground" serve different purposes, and their roles are not interchangeable.

In a bulk CMOS process technology the body of an NMOS is typically shorted to the silicon substrate which is positively doped and connected to the ground potential. In process technologies with a deep N-well it is possible to independently bias the body of the NMOS transistors. It is always possible to independently bias the body of a PMOS transistor. The body effect is the most linear and pronounced in silicon-on-insulator (SOI) technology processes. As shown in the cross-section of a typical SOI process the buried oxide under the channel acts as an insulator between the P-well and N-well and the channel of the transistors. The body here is controlled by the body contacts, which is P type for NMOS and N type for PMOS. There is a deep N-well under the P-well which isolates the body of the NMOS from P-substrate. The body of the NMOS can be biased with lower than 0V potential to increase the threshold voltage of the NMOS, and the body of the PMOS can be biased with higher than 0V potential to increase the threshold voltage of the PMOS. In SOI processes the control of the threshold voltages in this manner is much more linear and stronger than a bulk CMOS process.

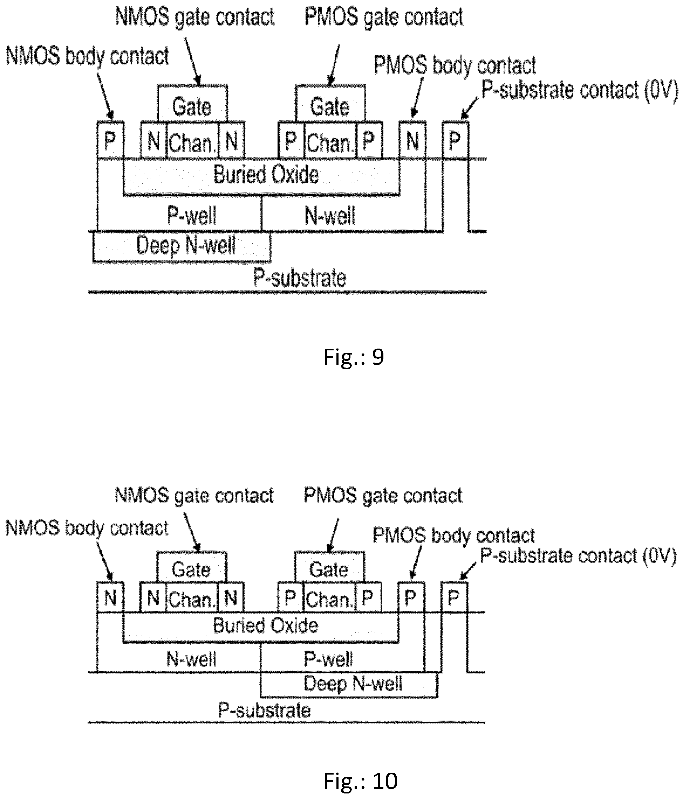

Figure 9 shows a cross section with alternated PIN compared to Figure 10. SOI processes can also have the option to be able to forward bias the body of the transistors as shown in the cross-section in Figure 10. In this case the PMOS has a P-well and deep N-well under its buried oxide layer, while the NMOS has an N-well. This allows to bias the NMOS with a higher than 0V potential to lower its threshold voltage, and bias the PMOS with a lower than 0V potential to lower its threshold voltage. Lowering the threshold voltage has the additional benefit of increasing the maximum operational frequency of a MOSFET.

This method can also be used to compensate for the offset of the slicers used in the receivers.

This method can also be used in conventional DFEs without loop-unrolling as shown in Figure 3. In this case the DAC in Figure 3 would drive the body terminal of the input pair transistors of the slicer.

The present method introduces an offset in the slicer of a decision-feedback equalizer (DFE) circuit by utilizing the body effect of MOSFET input transistors, achieving precise threshold voltage control without modifying traditional gate-source voltages or adding extra components. This approach provides a streamlined and efficient method for optimizing the slicer's performance in high-speed signal processing applications, particularly in digital communication systems where accurate decision feedback is essential.

The method begins by providing a slicer circuit in which the input transistors are implemented as metal-oxide-semiconductor field-effect transistors (MOSFETs). Each of these MOSFETs includes standard terminal configurations: gate, drain, source, and body terminals. The unique feature of this approach is the application of a control voltage specifically to the body terminals of the input transistors. This control voltage, applied through the body, induces a shift in the threshold voltage of each MOSFET, effectively introducing an offset within the slicer. This offset is achieved without altering the traditional gate-source voltage of the MOSFETs, thus preserving the conventional operation and design simplicity of the slicer circuit.

To generate this control voltage, a digital-to-analog converter (DAC) is employed, which enables precise and independent adjustment of the body terminal biases across each input transistor. This setup allows for adaptable threshold voltage control, making it possible to introduce offsets that improve the slicer's performance without modifying other aspects of the circuit's configuration. By directly biasing the body terminals through a DAC-generated control voltage, the method enhances the flexibility and accuracy of offset adjustments, a critical requirement for maintaining high data rates and low error rates in DFE circuits.

One of the significant advantages of this approach is that the offset is introduced solely through the body terminals of the MOSFETs, avoiding the need for additional transistors or current sources that could complicate the circuit and increase power demands. Traditional methods of offset adjustment often involve supplementary circuitry, which can introduce unwanted capacitive load and additional thermal noise, potentially degrading the slicer's performance. In contrast, by leveraging the body effect directly, this method achieves offset control with minimal impact on the slicer's design and operational efficiency.

Moreover, this method contributes to maintaining low energy consumption. The control voltage applied to the body terminals avoids any increase in power requirements, thus ensuring that the DFE circuit remains energy-efficient. This characteristic is essential for applications that demand both high-speed data processing and minimal power usage. In summary, this method provides a reliable and efficient solution for offset control in DFE slicers, with distinct technical advantages, including reduced component count, preservation of slicer performance, and sustained energy efficiency.

Herein analog-to-digital converter (DAC) is used as a general concept of a converter meaning that analog-to-digital converter (DAC) and digital-to-analog converter (ADC) are used interchangeably. Based on the conversion type the person skilled in the art recognizes the underlying meaning. Typically, the same circuits may be applied and therefore DAC and ADC refer to same concepts which are typically implemented to provide both functions in practice.

The terms analog-to-digital converter (ADC) and digital-to-analog converter (DAC) are typically distinct in electronics, as they perform opposite functions: an ADC converts continuous analog signals into discrete digital values, while a DAC converts digital values back into analog signals. However, in the context of the present invention, they can be used interchangeably as a general concept of "converter" due to the underlying principle of threshold control and signal adjustment that applies to both types of converters.

In this invention, the primary focus is on adjusting threshold values dynamically in response to changes in the incoming signal. This dynamic threshold adjustment could be applied to both ADCs and DACs, as both types of converters rely on precise signal evaluation at defined thresholds to perform accurate conversions. Whether converting analog inputs to digital outputs (as in ADCs) or adjusting digital inputs to control an analog output (as in DACs), the key concept remains the control over signal thresholds for precise conversion.

Thus, by treating ADCs and DACs interchangeably in this context, the invention emphasizes the broader idea of threshold modulation within converters in general, without limiting it to one specific conversion direction. This flexibility reflects the applicability of the invention to various conversion scenarios, enhancing its utility across different types of signal processing systems.

Further definitions apply in this description in case not defined otherwise at the respective occurrence thereof in the description as follows.

DFE: Decision-Feedback Equalizer: A type of equalizer used in digital communication systems to reduce inter-symbol interference (ISI) by dynamically adjusting thresholds based on previous decisions.

ISI: Inter-Symbol Interference: A form of signal distortion where one symbol interferes with subsequent symbols, common in high-speed data transmission.

MOSFET: Metal-Oxide-Semiconductor Field-Effect Transistor: A type of transistor used in electronics for amplifying or switching signals. It includes four terminals: gate, drain, source, and body (or backgate).

NMOS: N-channel Metal-Oxide-Semiconductor: A type of MOSFET with an N-type channel, which conducts when a positive voltage is applied to the gate relative to the source.

PMOS: P-channel Metal-Oxide-Semiconductor: A type of MOSFET with a P-type channel, which conducts when a negative voltage is applied to the gate relative to the source.

SNR: Signal-to-Noise Ratio: A measure of the signal strength relative to background noise, commonly used to evaluate signal quality in communication systems.

SOI: Silicon-on-Insulator: A semiconductor fabrication technique where a layer of silicon is placed on an insulating substrate, often used to improve performance in integrated circuits by reducing parasitic capacitance.

## Claims

1. A method for introducing an offset in a slicer of a decision-feedback equalizer (DFE) circuit, the method comprising:
- providing (100) a slicer that includes input transistors implemented as metal-oxide-semiconductor field-effect transistors (MOSFETs), each MOSFET having a gate terminal, a drain terminal, a source terminal, and a body terminal;
- applying (101) a control voltage to the body terminals of the input transistors to adjust their threshold voltages through the body effect, thereby introducing a desired offset in the slicer without altering gate-source voltages; and
- generating (102) the control voltage using a digital-to-analog converter (DAC) to independently bias the body terminals of the input transistors; wherein the application of the control voltage to the body terminals introduces (103) the offset without adding additional transistors or current sources, thereby avoiding degradation of the slicer's performance and preventing an increase in energy consumption.

2. The method of any one of the preceding claims, wherein the body terminal of each MOSFET is biased with an independently adjustable control voltage, allowing separate offset levels to be set for individual slicers within the DFE circuit.

3. The method of any one of the preceding claims, wherein the control voltage applied to the body terminals is varied dynamically during operation to maintain threshold voltage adjustments based on real-time signal conditions.

4. The method of any one of the preceding claims, further comprising calibrating the DAC used to generate the control voltage at the initialization of the DFE circuit to ensure precise offset adjustments across all operating conditions.

5. The method of any one of the preceding claims, wherein the DAC is configured to generate a range of control voltages that enable both positive and negative threshold adjustments, allowing for flexible offset control based on the specific requirements of the receiver.

6. The method of any one of the preceding claims, wherein the body terminals are biased to introduce opposing offsets across multiple slicers in a loop-unrolled DFE architecture, facilitating simultaneous threshold adjustments across all slicers.

7. The method of any one of the preceding claims, wherein the offset introduced by the body terminal biasing compensates for variations in the common-mode voltage of input signals to improve accuracy and signal integrity within the DFE circuit.

8. The method of any one of the preceding claims, wherein the control voltage applied to the body terminals is configured to reduce capacitive loading on the slicer input transistors, thereby enhancing the speed and performance of the DFE circuit.

9. The method of any one of the preceding claims, wherein the control voltage for body terminal biasing is adjusted periodically in response to environmental factors, such as temperature changes, to maintain consistent slicer performance.

10. The method of any one of the preceding claims, wherein the offset control provided through body terminal biasing is used in combination with additional filtering mechanisms in the DFE circuit to reduce noise and improve signal clarity.

11. The method of any one of the preceding claims, further comprising generating a feedback signal from the output of the slicer to adjust the DAC settings, enabling adaptive offset correction based on previous decision outcomes in the DFE circuit.

12. The method of any one of the preceding claims, wherein the slicer includes a differential amplifier configuration, and the control voltage applied to the body terminals is selected to balance the differential inputs and improve overall linearity of the slicer's output.

13. A system arrangement for introducing an offset in a slicer of a decision-feedback equalizer (DFE) circuit, comprising:
- a slicer that includes input transistors implemented as metal-oxide-semiconductor field-effect transistors (MOSFETs), each MOSFET having a gate terminal, a drain terminal, a source terminal, and a body terminal;
- a control unit for applying a control voltage to the body terminals of the input transistors to adjust their threshold voltages through the body effect, thereby introducing a desired offset in the slicer without altering gate-source voltages; and
- a control unit arranged to generate the control voltage using a digital-to-analog converter (DAC) to independently bias the body terminals of the input transistors; wherein the application of the control voltage to the body terminals introduces the offset without adding additional transistors or current sources, thereby avoiding degradation of the slicer's performance and preventing an increase in energy consumption.

14. A computer program product comprising instructions to cause the arrangement of claim 13 to execute the steps of the method of any one of claims 1 to 12.

15. A computer-readable medium having stored thereon the computer program of claim 14.
